# EUROPEAN PATENT SPECIFICATION

(11) **EP 3 888 122 B1**
(45) Date of publication and mention of the grant of the patent: **07.06.2023**
(21) Application number: 19888608.7
(22) Date of filing: 29.11.2019
(51) Int. Cl.: H01L 21/56, H01L 21/98, H01L 21/683, H01L 25/065, H01L 21/78, H01L 23/00, H01L 25/18, H01L 23/31

(54) **CHIP MOLDING STRUCTURE, WAFER LEVEL CHIP SCALE PACKAGING STRUCTURE AND MANUFACTURING METHOD THEREOF**
CHIPVERKAPSELUNGSTRUKTUR, CHIP-SCALE-GEHÄUSESTRUKTUR AUF WAFEREBENE UND HERSTELLUNGSVERFAHREN DAFÜR
STRUCTURE DE MOULAGE DE PUCE, STRUCTURE D'ENCAPSULATION SUR TRANCHES ET SON PROCÉDÉ DE FABRICATION

(30) Priority: 30.11.2018 CN 201811459386; 30.11.2018 CN 201822028036 U
(43) Date of publication of application: 06.10.2021
(73) Proprietor: Changxin Memory Technologies, Inc., Anhui 230000 (CN)
(72) Inventor: CHUANG, Ling-Yi, Hefei, Anhui 230000 (CN); LIN, Dingyou, Hefei, Anhui 230000 (CN)
(74) Representative: V.O.
(86) International application number: PCT/CN2019/121909
(87) International publication number: WO 2020/108602

(56) References cited:
- US-A1- 2012 088 332
- US-A1- 2015 364 432

## Description

### TECHNICAL FIELD

The present invention relates generally to the technical field of semiconductor production, and more specifically, but not by way of limitation, to a manufacturing method of a wafer level chip scale packaging structure.

### BACKGROUND

Different from chip packaging method, wafer level chip scale packaging (WLCSP) first conducts packaging and test on wafer level, then the wafer may be diced into individual chips. Therefore, upon the completion of the packaging, the size of the package may be substantially equal to the original size of the bare chip. US 2012/088332 A1 discloses a semiconductor package having a large capacity and minimized volume, and a method of manufacturing the semiconductor package. US 2015/364432 A1 discloses provides a method of manufacturing a semiconductor package in which faults, which are generated during a process of manufacturing the semiconductor package by stacking a plurality of semiconductor chips on a semiconductor wafer, are reduced and reliability is increased by improving a handling property.

In the molding process of wafer level packaging, a molding compound may initially be in a liquid state (or be heated to a liquid state), and the molding compound then may be cured through a cooling process. To ensure a predetermined molding density for the molding compound molded on the wafer surface, a certain injection molding pressure needs to be applied to the liquid molding compound within a mold.

In the molding process of existing wafer level packaging, the wafer may be clamped by annular upper and lower molds during the wafer level molding. Annular clamps of the molds may press the peripheral portions of the inner surface of the wafer to secure the wafer. Upon the completion of the molding, the annular clamps may be removed from the wafer.

While being pressed by the annular clamps, the peripheral portions of the wafer may be easily crushed or damaged, and the chips located at the peripheral portions of a neighboring wafer may also be affected, thus causing issues in molding quality and production yield.

In view of the above description, there is an urgent need for a solution that can overcome the issue that the peripheral portions of a wafer being susceptible to damage during molding and dicing processes of the wafer.

It is to be noted that the information disclosed in the above background is merely for strengthening the understanding on the background of the present invention and thus may include information not constituted into prior art known to a person of ordinary skill in the art.

### SUMMARY

In view of the deficiencies of existing technologies, the present invention provides a manufacturing method of a wafer level chip scale packaging structure, that at least solve the issue that the peripheral portions of a wafer being susceptible to damage during molding and dicing processes of the wafer.

Other characteristics and advantages of the present invention may become apparent from the following detailed description, or may be partially learnt from the practice of the present invention.

The present invention is directed to a method of making a wafer level chip scale packaging structure according to claim 1.

In some embodiments of the present invention, the method may further include: after the step of molding the plurality of bottom chips with a mold to form the packaging structure, separating the carrier and the packaging structure.

In some embodiments of the present invention, molding the plurality of bottom chips with a mold to form the packaging structure may include: placing the plurality of bottom chips in a recess of the mold, with an inner diameter of the mole being greater than an outer diameter of the wafer; filling the recess of the mold with a molding compound; and curing the molding compound.

In some embodiments of the present invention, molding the plurality of bottom chips with a mold to form the packaging structure may further include: covering side surfaces of the bottom chips mounted with the stacked chip sets with the molding compound, and covering an upper surface of the wafer with the molding compound.

In some embodiments of the present invention, the aforementioned method may further include: removing one or more bottom chips that are defective.

In some embodiments of the present invention, mounting a plurality of stacked chip sets on the plurality of bottom chips may include: mounting the plurality of stacked chip sets on the bottom chips tested to be normal.

In some embodiments of the present invention, separating the carrier and the packaging structure may include: separating the carrier and the packaging structure without removing the molding compound.

In some embodiments of the present invention, bonding the wafer with a carrier may include: bonding a surface of the wafer with the carrier through an adhesive tape.

Another aspect, which does not form part of the present invention but is useful for understanding it, is directed to a wafer level chip scale packaging structure. The structure may include: a plurality of bottom chips; a plurality of stacked chip sets, disposed on the plurality of bottom chips, with the plurality of bottom chips separated from each other by gaps; and a molding compound, covering side surfaces of the bottom chips.

In some examples, the gaps may each have a width in a range of 50 µm to 200 µm.

In some examples, the structure may further include: a carrier, bonded on bottom surfaces of the bottom chips.

In some examples, the bottom chips may include a controller chip or a silicon interposer.

In some examples, the structure may further include at least one of: a silicon through hole connecting a plurality of chips in one of the stacked chip sets; and, a mounting terminal disposed on the bottom surface of one of the bottom chips.

In some examples, the bottom chips and the stacked chip sets may be connected via one of: a bump, a cylindrical bump having a soldering flux on a top end, or a solder ball.

In some examples, the molding compound may cover a portion of a top surface of the bottom chips.

Another aspect, which does not form part of the present invention but is useful for understanding it, is directed to a chip packaging structure. The chip packaging structure may be manufactured with the manufacturing method of one of the aforementioned embodiments of the present invention. The chip packaging structure may include: a bottom chip; a stacked chip set, disposed on the bottom chip; and a molding compound, covering a side surface of the bottom chip.

In some examples, the bottom chip and the stacked chip set may be connected via one of: a bump, a cylindrical bump having a soldering flux on a top end, or a solder ball.

In some examples, the packaging structure may further include a mounting terminal disposed on a bottom surface of the bottom chip.

In some examples, the molding compound may cover a portion of a top surface of the bottom chip.

The technical solution provided by the embodiment of the present invention may include the following beneficial effects.

According to the technical solution provided by the exemplary embodiment of the present invention, by dicing a wafer into independent bottom chips and peripheral portions, with the peripheral portions being removed before molding, the bottom chips may be prevented from being damaged during the molding. Compared with existing technologies, the packaging quality and production yield of a WLCSP structure can be improved.

It is to be understood that both the foregoing general description and the following detailed description are exemplary and explanatory only and are not necessarily restrictive to the present invention.

### BRIEF DESCRIPTION OF THE DRAWINGS

The accompanying drawings, which are incorporated in and constitute a part of the specification, illustrate an embodiment of the present invention and examples useful for understanding the present invention and together with the specification, serve to explain the principles of the present invention. Apparently, the accompanying drawings in the following description are only some embodiments of the present invention, and a person of ordinary skill in the art can derive other drawings from the accompanying drawings without creative efforts.
FIG. 1 shows a schematic structural diagram of a wafer level chip scale packaging structure in the related art.
FIG. 2 shows a schematic structural diagram of a wafer level chip scale packaging structure in accordance with an example useful for understanding the present invention.
FIG. 3 shows a schematic structural diagram of a wafer level chip scale packaging structure in accordance with an example useful for understanding the present invention.
FIG. 4 shows a flowchart illustrating a manufacturing method of a wafer level chip scale packaging structure in accordance with an example useful for understanding the present invention.
FIG. 5 shows a flowchart illustrating a manufacturing method of a wafer level chip scale packaging structure in accordance with the present invention
FIGS. 6, 7, 8, 9, and 10 are sectional systematic views of step S401 to step S405.
FIG. 11 shows a structural diagram of a chip packaging structure in accordance with an example useful for understanding the present invention.

### DETAIL DESCRIPTION OF THE EMBODIMENTS

The exemplary embodiments of the present invention will be described more completely with reference to the accompanying drawings. However, the exemplary embodiments of the present invention can be implemented in various forms, and should not be understood as being limited to the embodiments described herein. Instead, these embodiments of the present invention are provided to make the present invention thorough and complete, and convey the concepts of the exemplary embodiments of the present invention to the person skilled in the art fully. Identical numerals in the drawings represent an identical or similar structure and thus the detailed descriptions thereof are omitted.

Although relative terms are used in the specification, for example, "on" and "under" are used to describe a relative relationship of one numeral component to another component, these terms used in the specification are merely for the convenience, for instance, according to an exemplary direction in the drawings. It is to be understood that if a numeral module is reversed to turn upside down, a component described to be "on" will become a component to be "under". Other relative terms such as "high", "low", "top", "bottom", "left" and "right" also have the similar meaning.

When a structure is "on" other structure, it may be indicated that the structure is integrally formed on the other structure, or indicated that the structure is "directly" disposed on the other structure, or indicated that the structure is "indirectly" disposed on the other structure via another structure.

Terms "a", "an", "one", "the", "said" and "at least one" are used to represent one or more elements/compositional portions/and the like. Terms "include", "including", "comprise", "comprising", "has" and "having" are used to represent a meaning of open inclusion and refer to that another elements/compositional portions/and the like may further be present besides the listed elements/compositional portions/and the like.

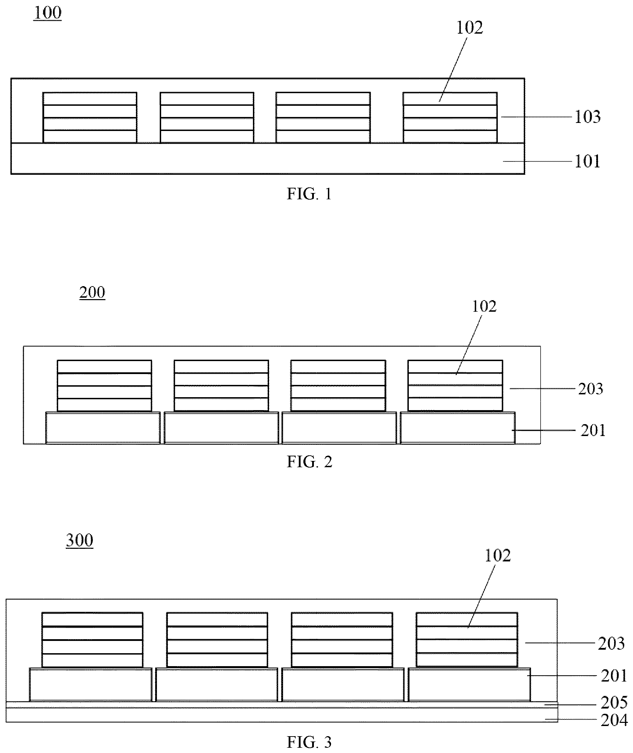

FIG. 1 shows a schematic structural diagram of a wafer level chip scale packaging structure in the related art. Referring to FIG. 1, in the wafer level chip scale packaging structure 100, a plurality of stacked chip sets 102 may be disposed on a wafer 101, and a molding compound 103 may cover an inner surface of the wafer 101. As the wafer has not been diced yet, the molding compound 103 may cover upper surfaces and side surfaces of the stacked chip sets 102, and cover portions of the inner surface of the wafer 101 not covered by the stacked chip sets 102.

As can be seen from the above description, when manufacturing the wafer level chip scale packaging structure, the wafer is first molded and then diced. Thus, when the wafer is placed between the upper and lower molds during the molding process, annular clamps of the upper and lower molds may press the peripheral portions of the inner surface (i.e., a surface of the wafer 101 facing upwards as shown in FIG. 1) of the wafer, thereby causing damage to the peripheral portions of the wafer and adversely affecting the packaging quality and production yield.

In the manufacturing process of the wafer level chip scale packaging structure provided by the present invention, instead of first molding the wafer followed by dicing the wafer, the wafer is diced first, and then, after the peripheral portions of the wafer are removed, the bottom chips are molded. Before the wafer is diced, a carrier may be bonded on an outer surface (i.e., a bottom surface) of the wafer. The carrier then may be removed after the inner surfaces (i.e., the top surfaces) of the bottom chips have been molded. Therefore, when the wafer is clamped by the upper and lower molds during the molding process, the annular clamp of the molds may press on the carrier, the upper mold no longer presses and contacts the peripheral portions of the wafer, the clamping stress of the mold is not directly transferred to the bottom chip. Thus the peripheral portions of the wafer are not susceptible to damage. The exemplary embodiments of the present invention will be described below in detail with reference to the accompanying drawings.

FIG. 2 shows a schematic structural diagram of a wafer level chip scale packaging structure in accordance with an example useful for understanding the present invention. Referring to FIG. 2, the wafer level chip scale packaging structure 200 may include: a plurality of bottom chips 201; a plurality of stacked chip sets 102, disposed on the plurality of bottom chips. The multiple bottom chips may be separated from each other by gaps. The structure may further include a molding compound 203, covering inner surfaces of the bottom chips 201 and side surfaces of the bottom chips 201. As shown in FIG. 2, the plurality of bottom chips 201 may be separated from each other by gaps, and the gaps may be filled with the molding compound 203.

In this example, a wafer is diced before being molded, and non-chip peripheral blocks at the periphery of the wafer (i.e., peripheral portions of the wafer) may be removed, so that a molding compound may completely enclose bottom chips to prevent the bottom chips from being damaged by an external force. Thus, the packaging and manufacturing quality of the semiconductor device may be improved.

In this example, the gaps may each have a width in a range of 50 µm to 200 µm. For example, each gap between the plurality of bottom chips may be: 80 µm, 110 µm, 140 µm or 170 µm.

The wafer may be diced by a diamond knife or a laser. Generally, a diamond knife may have a thickness in a range of 10 µm to 100 µm, so the width of each gap between the plurality of bottom chips is greater than the thickness of a diamond knife.

The plurality of stacked chip sets may include at least one semiconductor bare chip disposed on the bottom chips, and it may also include at least one integrated circuit (IC) disposed on the bottom chips. Each bottom chip may correspond, and be electrically connected, to one stacked chip set.

In some examples, the bottom chips may include a controller chip or a silicon interposer. The IC surfaces (i.e., the inner surfaces) of the bottom chips may face towards the stacked chip sets.

FIG. 3 shows a schematic structural diagram of a wafer level chip scale packaging structure in accordance with another example. The wafer level chip scale packaging structure 300, as shown in FIG. 3, and the wafer level chip scale packaging structure 200, as shown in FIG. 2, may each include a plurality of bottom chips 201, a plurality of stacked chip sets 102 and a molding compound 203. The difference between these two structures is that the wafer level chip scale packaging structure 300 may further include a carrier 204. The carrier 204 may be bonded with outer surfaces of the bottom chips 201 through an adhesive tape 205.

The bonding between the carrier 204 and the wafer may prevent the warpage of the wafer due to thin thickness of the wafer. The carrier may be a hard glass or a dicing tape.

A plurality of chips in one of the stacked chip sets 102 may be connected via a silicon through hole. The silicon through hole may also be referred to as a through silicon via (TSV).

The bottom chips and the stacked chip sets are connected via one of: a bump, a cylindrical bump having a soldering flux on a top end, or a solder ball.

A mounting terminal may be disposed on the outer surface of at least one of the bottom chips. The mounting terminal may also be referred to as a mounting combination terminal, and may electrically connect the bottom chip to other devices. The mounting terminal may also be a welded ball or the bump, and may also be the cylindrical bump with the soldering flux on the top end.

Additionally, it is to be noted that although the schematic diagrams shown in FIGS. 2 and 3 only include four bottom chips and four stacked chip sets, these schematic diagrams are merely exemplary systematic diagrams drawn to explaining the packaging structure. The wafer level chip scale packaging structure of the present invention may include multiple bottom chips and multiple stacked chip sets, with the exact numbers of the bottom chips and the stacked chip sets not being limited by the schematic diagrams of FIGS. 2 and 3.

In the wafer level chip scale packaging structure provided by the example, a wafer is first diced into individual bottom chips and the peripheral portions of the wafer. Then, after the peripheral portions are removed, the bottom chips are molded. Thus, the bottom chips may be prevented from being damaged during the molding process. Compared with existing technologies, the packaging quality and production yield of a WLCSP structure may be improved.

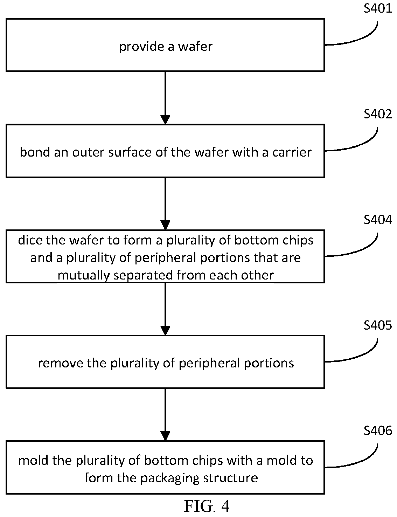

FIG. 4 shows a flowchart illustrating a manufacturing method of a wafer level chip scale packaging structure in accordance with an example not forming part of the present invention.

As shown in FIG. 4, the manufacturing method may include the following steps.

In step S401, a wafer is provided. The wafer includes a plurality of bottom chips.

In step S402, an outer surface of the wafer is bonded with a carrier.

In step S404, the wafer is diced to form the plurality of bottom chips and the peripheral portions of the wafer that are mutually separated from each other.

In step S405, the peripheral portions of the wafer are removed.

In step S406, the plurality of bottom chips are molded with a mold to form the packaging structure.

In this example which does not form part of the present invention, a wafer is diced before being molded, and non-chip peripheral blocks at the periphery of the wafer (i.e., the peripheral portions of the wafer) are removed, so that a molding compound may completely enclose bottom chips to prevent the bottom chips from being damaged by an external force. Thus, the packaging and manufacturing quality of the semiconductor device may be improved.

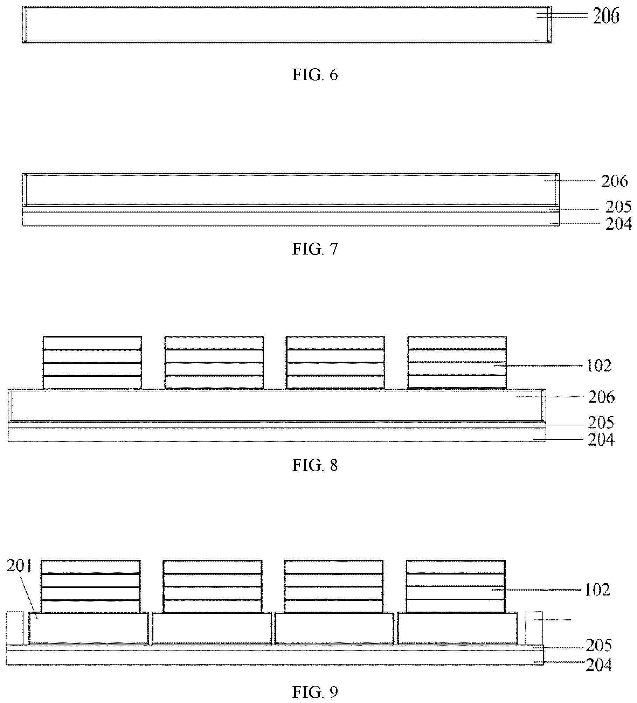

Upon the completion of step S401, a structure with a sectional systematic view as shown in FIG. 6 may be formed. The wafer 206 includes a plurality of bottom chips 201.

In step S402, the wafer may be bonded with the carrier through an adhesive tape. Upon the completion of step S402, a structure with a sectional systematic view as shown in FIG. 7 may be formed. As shown in FIG. 7, the outer surface of the wafer 206 may be bonded with the carrier 204 through the adhesive tape 205. The bonding between the carrier 204 and the wafer 206 may prevent the warpage of the wafer due to thin thickness of the wafer. In addition, the carrier 204 may further be bonded with an adhesive material via the wafer. The adhesive material may be heated to weaken its bonding force to the wafer to ease the removal of the carrier from to the wafer.

Step S404 may include a single ion dicing process on the wafer. Upon the completion of step S404, a structure with a sectional systematic view as shown in FIG. 9 may be formed.

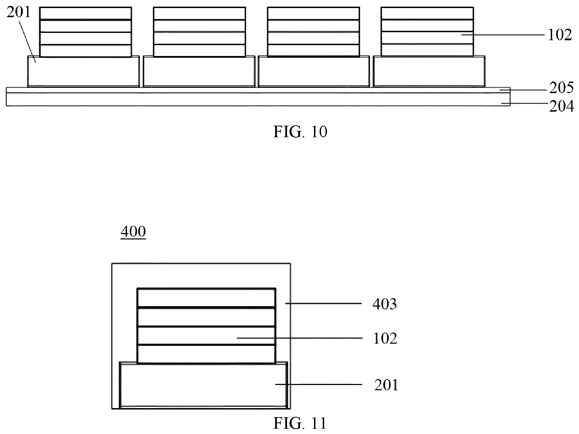

In step S405, when removing the peripheral portions of the wafer, one or more bottom chips that are tested to be defective may also be removed, thereby improving the production yield. Upon the completion of step S405, a structure with a sectional systematic view as shown in FIG. 10 may be formed.

In step S406, the plurality of bottom chips may be placed in a recess of the mold. An inner diameter of the mold may be greater than an outer diameter of the wafer. Then, the recess of the mold may be filled with a molding compound, which may then be cured. Upon the completion of step S406, a structure with a sectional systematic view as shown in FIG. 3 may be formed.

When the molding compound is completely cured, a clamp of the mold may be separated from the carrier having the molding compound. At this time, the molding compound has completely molded and enclosed the stacked chip sets and the bottom chips. That is, the molding compound may enclose six surfaces of each of the stacked chip sets and the bottom chips.

Specifically, in the process of molding the plurality bottom chips with the mold, the molding compound may cover side surfaces of the plurality of bottom chips provided with the stacked chip sets, and may cover an upper surface of the wafer.

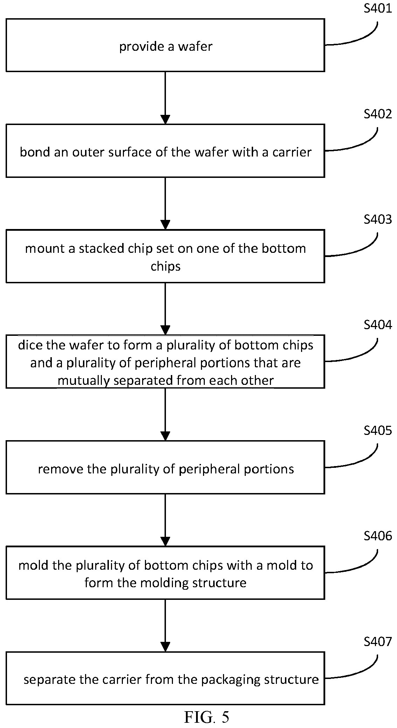

FIG. 5 shows a flowchart illustrating a manufacturing method of a wafer level chip scale packaging structure in accordance with the present invention. Referring to FIG. 5, in this method, steps S401, S402, S404, S405 and S406 may be the same as corresponding steps in the manufacturing method of FIG. 4. The difference between these two methods is that the manufacturing method of FIG. 5 further includes the following steps.

In step S403, a plurality of stacked chip sets is mounted on the bottom chips.

In step S407, the carrier may be separated from the packaging structure.

In step S403, the stacked chip sets may be disposed only on the bottom chips that have been tested to be normal. Upon the completion of step S403, a structure with a sectional systematic view as shown in FIG. 8 may be formed. Bottom chips that have been tested to be defective may be removed together with the peripheral portions of the wafer in step S405. If a stacked chip set is disposed on a bottom chip that has been tested to be defective, and a finished product is formed by going through a molding process, the finished product will be determined to be defective by a subsequent test process, thereby causing the scrap of an otherwise good-working stacked chip set. In step 403, by disposing the stacked chip sets only on the bottom chips that have been tested to be normal, unnecessary scrapping of the stacked chip sets may be prevented.

In some examples not forming part of the present invention, step S403 may be performed after step S404.

In step S407, the packaging structure may be separated from the carrier without removing the molding compound. Upon the completion of step S407, a structure with a sectional systematic view as shown in FIG. 2 may be formed.

Subsequently, the wafer level chip scale packaging structure may be subjected to the single ion dicing process to form individual chip packaging structures. A diamond dicing process or a laser dicing process may be used during this process.

According to the manufacturing method of the wafer level chip scale packaging structure provided by this exemplary embodiment of the present invention, by dicing a wafer into independent bottom chips and the peripheral portions of the wafer, with the peripheral portions being removed before molding, the bottom chips may be prevented from being damaged during the molding. Compared with existing technologies, the packaging quality and production yield of a WLCSP structure may be improved.

FIG.11 shows a structural diagram of a chip packaging structure in accordance with an example not forming part of the present invention but useful for understanding it. The structure may be manufactured according to the manufacturing method of the wafer level chip scale packaging structure in any of the aforementioned examples or the embodiment of the present invention. As shown in FIG. 11, the chip packaging structure 400 may include: a bottom chip 201; a stacked chip set 102, disposed on the bottom chip 201; and a molding compound 403, covering an inner surface of the bottom chip 201 and a side surface of the bottom chip 201.

The chip packaging structure may be obtained by applying an single ion dicing process on the wafer level chip scale packaging structure 200 described in the aforementioned example.

The bottom chip may include a controller chip or a silicon interposer.

A plurality chips in the stacked chip set 102 may be connected via a silicon through hole. The silicon through hole may also be referred to as a TSV. In the chip packaging structure, the stacked chip set may include at least two ICs or at least two bare chips. The two ICs, or the two bare chips, may be connected via the silicon through hole.

The bottom chip and the stacked chip set may be connected via one of: a bump, a cylindrical bump having a soldering flux on a top end, or a solder ball.

A mounting terminal may be disposed on the outer surface of the bottom chip. The mounting terminal may also be referred to as a mounting combination terminal, and may electrically connect the bottom chip to other devices. The mounting terminal may also be a welded ball or a bump, and may also be a cylindrical bump with the soldering flux on the top end.

According to the chip packaging structure, by dicing a wafer into independent bottom chips and the peripheral portions of the wafer, with the peripheral portions being removed before molding, the bottom chips may be prevented from being damaged during the molding. Compared with existing technologies, the packaging quality and production yield of a WLCSP structure may be improved.

Other embodiments of the present invention will be apparent to the person skilled in the art from consideration of the specification and practice of the present invention disclosed here. The present invention is intended to cover any variations, uses, or adaptations of the present invention following the general principles thereof and including such departures from the present invention as come within known or customary practice in the art.

It is to be understood that the present invention is not limited to the accurate structures described above and shown in the accompanying drawings, and may be subjected to various modifications and changes without departing from the scope of the present invention. The scope of the present invention is only limited by the appended claims.

## Claims

1. A method of making a wafer level chip scale packaging (WLCSP) structure (200, 300), **characterized in that** the method comprises following steps in sequence:
providing (S401) a wafer (206), comprising a plurality of bottom chips (201);
bonding (S402) the wafer (206) with a carrier (204);
mounting (S403) a plurality of stacked chip sets (102) on the plurality of bottom chips (201);
dicing (S404) the wafer (206) to separate the plurality of bottom chips (201) from each other and from a plurality of peripheral portions of the wafer;
removing (S405) the plurality of peripheral portions; and
molding (S406) the plurality of bottom chips (201) with a mold to form the packaging structure.

2. The method of claim 1, further comprising: after the step of molding (S406) the plurality of bottom chips (201) with a mold to form the packaging structure,
separating (S407) the carrier (204) and the packaging structure.

3. The method of claim 2, wherein molding (S406) the plurality of bottom chips with a mold to form the packaging structure comprises:
placing the plurality of bottom chips (201) in a recess of the mold, wherein an inner diameter of the mold is greater than an outer diameter of the wafer(206);
filling the recess of the mold with a molding compound (203);
curing the molding compound (203); and
wherein molding (S406) the plurality of bottom chips (201) with a mold to form the packaging structure further comprises:
covering side surfaces of the bottom chips (201) mounted with the stacked chip sets (102) with the molding compound (203), and covering an upper surface of the wafer (206) with the molding compound (203).

4. The method of claim 3, further comprising:
removing one or more bottom chips (201) that are defective.

5. The method of claim 4, wherein mounting (S403) a plurality of stacked chip sets (102) on the plurality of bottom chips (201) comprises:
mounting the plurality of stacked chip sets (102) on the bottom chips (201) tested to be normal.

6. The method of claim 5, wherein separating (S407) the carrier (204) and the packaging structure comprises:
separating, without removing the molding compound (203), the carrier (204) and the packaging structure.

7. The method of claim 6, wherein bonding (S402) the wafer (206) with a carrier (204) comprises:
bonding a surface of the wafer (206) with the carrier (204) with an adhesive tape (205).

## Patentansprüche

1. Verfahren zur Herstellung einer Wafer-Level-Chip-Scale-Packaging (WLCSP)-Struktur (200, 300), **dadurch gekennzeichnet, dass** das Verfahren die folgenden Schritte in Folge umfasst:
Bereitstellen (S401) eines Wafers (206), der eine Vielzahl von Bodenchips (201) umfasst;
Verbinden (S402) des Wafers (206) mit einem Träger (204);
Montieren (S403) einer Vielzahl von gestapelten Chipsätzen (102) auf der Vielzahl von Bodenchips (201);
Würfeln (S404) des Wafers (206), um die Vielzahl von Bodenchips (201) voneinander und von einer Vielzahl von Randabschnitten des Wafers zu trennen;
Entfernen (S405) der Vielzahl von Randabschnitten; und
Formen (S406) der Vielzahl von Bodenchips (201) mit einer Form, um die Verpackungsstruktur zu bilden.

2. Verfahren nach Anspruch 1, ferner umfassend: nach dem Schritt des Formens (S406) der Mehrzahl von Bodenchips (201) mit einer Form, um die Verpackungsstruktur zu bilden,
Trennen (S407) des Trägers (204) und der Verpackungsstruktur.

3. Verfahren nach Anspruch 2, wobei das Formen (S406) der Vielzahl von Bodenchips mit einer Form zur Bildung der Verpackungsstruktur umfasst:
Platzieren der Vielzahl von Bodenchips (201) in einer Ausnehmung der Form, wobei ein Innendurchmesser der Form größer ist als ein Außendurchmesser des Wafers (206);
Füllen der Ausnehmung der Form mit einer Formmasse (203);
Aushärten der Formmasse (203); und
wobei das Formen (S406) der Vielzahl von Bodenchips (201) mit einer Form zur Bildung der Verpackungsstruktur ferner umfasst:
Bedecken von Seitenoberflächen der Bodenchips (201), die mit den gestapelten Chipsätzen (102) montiert sind, mit der Formmasse (203), und Bedecken einer oberen Oberfläche des Wafers (206) mit der Formmasse (203).

4. Verfahren nach Anspruch 3, das ferner umfasst:
Entfernen eines oder mehrerer defekter Bodenchips (201).

5. Verfahren nach Anspruch 4, wobei das Montieren (S403) einer Vielzahl von gestapelten Chipsätzen (102) auf der Vielzahl von Bodenchips (201) umfasst:
Montieren der mehreren gestapelten Chipsätze (102) auf den als normal getesteten Bodenchips (201).

6. Verfahren nach Anspruch 5, wobei das Trennen (S407) des Trägers (204) und der Verpackungsstruktur umfasst:
Trennen, ohne die Formmasse (203) zu entfernen, des Trägers (204) und der Verpackungsstruktur.

7. Verfahren nach Anspruch 6, wobei das Verbinden (S402) des Wafers (206) mit einem Träger (204) umfasst:
Verbinden einer Oberfläche des Wafers (206) mit dem Träger (204) mit einem Klebeband (205).

## Revendications

1. Procédé de fabrication d'une structure (200, 300) de mise sous boîtier à l'échelle de la puce au niveau de la plaquette (WLCSP), **caractérisé en ce que** le procédé comprend les étapes consistant en séquence à :
fournir (S401) une plaquette (206), comprenant une pluralité de puces inférieures (201);
coller (S402) la plaquette (206) avec un support (204);
monter (S403) une pluralité d'ensembles de puces empilés (102) sur la pluralité de puces inférieures (201);
découper (S404) la plaquette (206) pour séparer la pluralité de puces inférieures (201) les unes des autres et d'une pluralité de parties périphériques de la plaquette ;
retirer (S405) la pluralité de parties périphériques ; et
mouler (S406) la pluralité de puces inférieures (201) avec un moule pour former la structure de boîtier.

2. Procédé selon la revendication 1, comprenant en outre : après l'étape de moulage (S406) de la pluralité de puces inférieures (201) avec un moule pour former la structure de boîtier,
la séparation (S407) du support (204) de la structure de boîtier.

3. Procédé selon la revendication 2, dans lequel le moulage (S406) de la pluralité de puces inférieures avec un moule pour former la structure de boîtier comprend les étapes consistant à:
placer la pluralité de puces inférieures (201) dans un évidement du moule, dans lequel un diamètre interne du moule est supérieur à un diamètre externe de la plaquette (206) ;
remplir l'évidement du moule avec un composé de moulage (203);
durcir le composé de moulage (203); et
dans lequel le moulage (S406) de la pluralité de puces inférieures (201) avec un moule pour former la structure de boîtier comprend en outre les étapes consistant à:
recouvrir les surfaces latérales des puces inférieures (201) montées avec les ensembles de puces empilés (102) avec le composé de moulage (203), et recouvrir une surface supérieure de la plaquette (206) avec le composé de moulage (203).

4. Procédé selon la revendication 3, comprenant en outre l'étape consistant à :
enlever une ou plusieurs puces inférieures (201) qui sont défectueuses.

5. Procédé selon la revendication 4, dans lequel le montage (S403) d'une pluralité d'ensembles de puces empilés (102) sur la pluralité de puces inférieures (201) comprend l'étape consistant à :
monter la pluralité d'ensembles de puces empilés (102) sur les puces inférieures (201) testées comme étant normales.

6. Procédé selon la revendication 5, dans lequel la séparation (S407) du support (204) de la structure de boîtier comprend :
la séparation, sans enlèvement du composé de moulage (203), du support (204) et de la structure de boîtier.

7. Procédé selon la revendication 6, dans lequel le collage (S402) de la plaquette (206) avec un support (204) comprend l'étape consistant à :
coller une surface de la plaquette (206) avec le support (204) avec un ruban adhésif (205).
